# EUROPÄISCHE PATENTANMELDUNG

(11) **EP 4 538 413 A1**
(43) Veröffentlichungstag der Anmeldung: **16.04.2025**
(21) Anmeldenummer: 23203074.2
(22) Anmeldetag: 11.10.2023
(51) Int. Cl.: C23C 16/02, B05D 1/00, B05D 3/10, B05D 5/08, C23C 16/30

(54) **ANTIHAFTBESCHICHTUNG UND HERSTELLUNGSVERFAHREN**

(71) Anmelder: Joanneum Research Forschungsgesellschaft mbH, 8010 Graz (AT); Technische Universität Graz, 8010 Graz (AT)
(72) Erfinder: Stadlober, Barbara, 8044 Graz (AT); Coclite, Anna Maria, 8010 Graz (AT); Nees, Dieter, 8160 Thannhausen (AT); Pfleger, Jasmin, 8255 St. Jakob im Walde (AT)
(74) Vertreter: Strehl & Partner mbB

(57) **Zusammenfassung**

Ein Verfahren zum Herstellen eines antihaftbeschichteten Substrats, welches das Aufbringen einer Antihaftverbindung auf ein Substrat mittels chemischer Gasphasenabscheidung umfasst, wobei die Antihaftverbindung eine oberflächenaktive Verbindung mit einer polymerisierbaren Gruppe ist und das Substrat metallhaltig ist und mit einem Haftvermittler modifiziert ist, wobei der Haftvermittler eine Phosphorsäure- oder Phosphonsäuregruppe sowie eine mit der Antihaftverbindung umsetzbare Gruppe aufweist; ein mit diesem Verfahren herstellbares antihaftbeschichtete Substrat; und die Verwendung des antihaftbeschichteten Substrats als Werkzeug zum Prägen oder Formen von Mikro- oder Nanostrukturen.

## Beschreibung

### Gebiet der Erfindung

Die vorliegende Erfindung betrifft ein Verfahren zum Herstellen eines antihaftbeschichteten Substrats, ein mit diesem Verfahren herstellbares antihaftbeschichtete Substrat und die Verwendung des antihaftbeschichteten Substrats als Werkzeug zum Prägen oder Formen von Mikro- oder Nanostrukturen.

### Stand der Technik

US 2013280485 A1 offenbart ein Verfahren zur Herstellung von hydrophoben Oberflächen durch Pfropfen eines Polymers auf Oberflächen mittels initiierter chemischer Dampfabscheidung (iCVD). Das Polymer ist Poly(perfluoralkylacrylat) und wird durch Polymerisation von perfluorierten Acrylaten hergestellt.

### Durch die Erfindung zu lösende Aufgaben

Der vorliegenden Erfindung liegt die Aufgabe zugrunde, eine effektive, konforme und stabile Antihaftbeschichtung auf einem Substrat sowie ein Verfahren zur Herstellung eines antihaftbeschichteten Substrats bereitzustellen.

### Zusammenfassende Darstellung der Erfindung

Die Aufgabe wurde durch Bereitstellen eines antihaftbeschichteten Substrats, das über einen Haftvermittler mit einer Antihaftverbindung verbunden ist, und eines Verfahrens zu dessen Herstellung gelöst.

Der Gegenstand der vorliegenden Erfindung ist durch die folgenden Aspekte definiert.
[1] Verfahren zum Herstellen eines antihaftbeschichteten Substrats, welches das Aufbringen einer Antihaftverbindung auf ein Substrat mittels chemischer Gasphasenabscheidung umfasst, wobei die Antihaftverbindung eine oberflächenaktive Verbindung mit einer polymerisierbaren Gruppe ist und das Substrat metallhaltig ist und mit einem Haftvermittler modifiziert ist, wobei der Haftvermittler eine Phosphorsäure- oder Phosphonsäuregruppe sowie eine mit der Antihaftverbindung umsetzbare Gruppe aufweist.
   [1-1] Verfahren nach Aspekt [1], wobei das Aufbringen der Antihaftverbindung und die Polymerisation der polymerisierbaren Gruppe gleichzeitig erfolgen.
   [1-2] Verfahren nach einem der vorstehenden Aspekte, wobei die mit der Antihaftverbindung umsetzbare Gruppe des Haftvermittlers mit der polymerisierbaren Gruppe der Antihaftverbindung reagiert.
   [1-3] Verfahren nach einem der vorstehenden Aspekte, wobei bei Polymerisation der polymerisierbaren Gruppe der Antihaftverbindung die mit der Antihaftverbindung umsetzbare Gruppe des Haftvermittlers als polymerisierbare Gruppe in das Polymer eingebaut werden kann.
   [1-4] Verfahren nach einem der vorstehenden Aspekte, wobei die polymerisierbare Gruppe der Antihaftverbindung und die mit der Antihaftverbindung umsetzbare Gruppe des Haftvermittlers die gleiche Art von Gruppe sind.
   [1-5] Verfahren nach einem der vorstehenden Aspekte, wobei das Molekulargewicht der Antihaftverbindung weniger als 1000 g/mol ist.
   [1-6] Verfahren nach einem der vorstehenden Aspekte, wobei das Molekulargewicht des Haftvermittlers weniger als 2000 g/mol.
   [1-7] Verfahren nach einem der vorstehenden Aspekte, wobei die Schichtdicke der aufgebrachten Antihaftverbindung auf dem Substrat weniger als 200 nm beträgt.
[2] Verfahren nach einem der vorstehenden Aspekte, wobei das Substrat ein Metall oder eine Metalllegierung ist.
[3] Verfahren nach einem der vorstehenden Aspekte, wobei die chemische Gasphasenabscheidung eine initiierte chemische Gasphasenabscheidung ist.
[4] Verfahren nach einem der vorstehenden Aspekte, wobei die Antihaftverbindung eine perfluorierte Verbindung ist.
[5] Verfahren nach einem der vorstehenden Aspekte, wobei die polymerisierbare Gruppe eine polymerisierbare Kohlenstoff-Kohlenstoff-Doppelbindung ist.
   [5-1] Verfahren nach einem der vorstehenden Aspekte, wobei die mit der Antihaftverbindung umsetzbare Gruppe des Haftvermittlers eine Kohlenstoff-Kohlenstoff-Doppelbindung ist.
[6] Verfahren nach einem der vorstehenden Aspekte, wobei die Antihaftverbindung ein (Meth)acrylsäureester eines perfluorierten Oligoethers mit mindestens zwei CF₃-Gruppen ist.
   [6-1] Verfahren nach Aspekt [6], wobei der Oligoether zwei bis sechs Ethereinheiten aufweist.
   [6-2] Verfahren nach Aspekt [6] oder [6-1], wobei alle Ethereinheiten eine CF₃-Gruppe aufweisen.
[7] Verfahren nach einem der vorstehenden Aspekte, wobei die Antihaftverbindung 1H,1H-Perfluoro(2,5-dimethyl-3,6-dioxanonanoyl)acrylat ist.
[8] Verfahren nach einem der vorstehenden Aspekte, wobei der Haftvermittler ein Diester eines Diols mit Phosphorsäure und (Meth)acrylsäure, eine Vinylphosphonsäure oder eine Allylphosphonsäure ist.
   [8-1] Verfahren nach Aspekt [8], wobei das Molekulargewicht des Diols weniger als 250 g/mol, vorzugsweise weniger als 100 g/mol ist.
[9] Verfahren nach einem der vorstehenden Aspekte, wobei das Aufbringen der Antihaftverbindung unter Einsatz eines Vernetzers erfolgt.
   [9-1] Verfahren nach Aspekt [9], wobei die polymerisierbare Gruppe der Antihaftverbindung eine polymerisierbare Kohlenstoff-Kohlenstoff-Doppelbindung ist und der Vernetzer mindestens zwei damit umsetzbare Kohlenstoff-Kohlenstoff-Doppelbindungen aufweist.
[10] Verfahren nach einem der vorstehenden Aspekte, wobei die chemische Gasphasenabscheidung eine initiierte chemische Gasphasenabscheidung ist, die Antihaftverbindung ein (Meth)acrylsäureester eines perfluorierten Oligoethers mit mindestens zwei CF₃-Gruppen ist und der Haftvermittler ein Diester eines Diols mit Phosphorsäure und (Meth)acrylsäure ist.
[11] Antihaftbeschichtetes Substrat, herstellbar durch ein Verfahren nach einem der Aspekte [1] bis [10].
[12] Antihaftbeschichtetes Substrat nach Aspekt [11], das ein Prägewerkzeug oder Formwerkzeug ist.
[13] Antihaftbeschichtetes Substrat nach Aspekt [12], wobei das Prägewerkzeug oder Formwerkzeug zur Replikation von Mikro- oder Nanostrukturen geeignet ist.
   [13-1] Antihaftbeschichtetes Substrat nach Aspekt [13], wobei das Prägewerkzeug oder Formwerkzeug Erhebungen mit einer Höhe von 1 nm bis 200 µm, vorzugsweise 10 nm bis 100 µm, stärker bevorzugt 100 nm bis 50 µm aufweist.
[14] Verwendung eines antihaftbeschichteten Substrats nach Aspekt [11] oder [12] als Werkzeug zum Prägen oder Formen von Mikro- oder Nanostrukturen.
   [14-1] Verwendung nach Aspekt [14], wobei die Antihaftbeschichtung des Werkzeugs beim Prägen einen Prägelack kontaktiert, der nach seiner Aushärtung die Mikro- oder Nanostrukturen aufweist.
   [14-2] Verwendung nach Aspekt [14] oder [14-1], wobei das Prägen ein UV-Prägeverfahren ist.

### Vorteile der Erfindung

Die Verwendung eines Werkzeugs, das ein erfindungsgemäßes antihaftbeschichtetes Substrat ist, in einem Präge- und Formverfahren ermöglicht die rückstands- und fehlerfreie Entformung, also die Trennung von Werkzeug und geformtes Material, und damit eine Verbesserung der Qualität von Antihaftschichten.

Die Antihaftbeschichtung weist eine geringe Schichtdicke auf und zeigt hohe Konformität, starke Hydrophobie bzw. Omniphobie (d.h. niedrige Oberflächenenergie) sowie mechanische und chemische Stabilität in multiplen UV-Prägeprozessen.

Durch die Haftvermittlung zum Prägewerkzeug sowie ggf. durch eine zusätzliche Quervernetzung der iCVD-Schicht werden zudem die Lebensdauer der Antihaftbeschichtung und somit die Prägeprozessstabilität deutlich verbessert.

### Ausführungsformen der Erfindung

In dem erfindungsgemäßen Verfahren kann als Substrat jede metallhaltige Substanz eingesetzt werden, die mit dem Haftvermittler modifiziert werden kann. Die metallhaltige Substanz kann ein reines Metall wie oder eine Legierung sein. Beispiele für Metalle sind Nickel, Stahl, Eisen, Zink oder Aluminium.

Die Auftragung der Antihaftverbindung erfolgt durch chemische Gasphasenabscheidung (CVD). Beispiele für eine CVD sind die plasmaunterstützte chemische Gasphasenabscheidung (PECVD) und die initiierte chemische Gasphasenabscheidung (iCVD) erfolgen, die beispielsweise aus US 2013280485 A1 bekannt ist. Ein iCVD-Verfahren ist bevorzugt, da es schonendes und substratunabhängiges Verfahren ist, bei dem beispielsweise keine Schädigung der Mikro- und Nanostrukturen durch die Plasmabehandlung auftritt. Mit einem iCVD-Verfahren kann eine stabile, konforme und omniphobe Polymerbeschichtung auf ein Substrat aufgebracht werden. In einem iCVD-Verfahren kann ein Initiator mit hinreichendem Dampfdruck verwendet werden, der beispielsweise aus der Gruppe ausgewählt ist, die aus tert-Butylperoxid, tert-Amylperoxid, Triethylamin, tert-Butylperoxybenzoat, Benzophenon und 2,2'-Azobis(2-methylpropan) besteht.

Als Antihaftverbindung kann jede Verbindung eingesetzt werden, die mit einem Verfahren zur chemischen Gasphasenabscheidung auf ein Substrat abgeschieden werden können, die eine oberflächenaktive Verbindung mit der gewünschten Antihafteigenschaft ist und die eine polymerisierbare Gruppe aufweist. Die Antihaftverbindung kann mehr als eine polymerisierbare Gruppe aufweisen, so dass bei der Polymerisation Vernetzungen gebildet werden, welche die Stabilität der Beschichtung erhöhen. Die Antihaftverbindung unterscheidet sich von dem Haftvermittler. Die Antihaftverbindung enthält keine Phosphorsäure- oder Phosphonsäuregruppe und/oder der Haftvermittler ist nicht signifikant oberflächenaktiv.

Als oberflächenaktive Verbindung kann eine beliebige Verbindung eingesetzt werden, die in einer Beschichtung auf einer Metalloberfläche die Hafteigenschaften der Oberfläche verändert. Beispiele für oberflächenaktive Verbindungen sind Alkane, Polysiloxane oder perfluorierte Verbindungen, wobei perfluorierte Verbindungen und insbesondere perfluorierte Oligoether bevorzugt sind. Hierin bezeichnet die Vorsilbe "oligo" zwei bis sechs, vorzugsweise drei bis sechs Einheiten, die nicht identisch sein müssen. Perfluoriert bedeutet, dass an mindestens einem Kohlenstoffatom die Wasserstoffatome vollständig durch Fluoratome ersetzt worden sind.

Die Antihaftverbindungen werden in der Regel in einer Polyreaktion umgesetzt, bei der die reaktionsfähige Gruppen unter dem Einfluss von Wärme, Licht, ionisierender Strahlung oder chemisch (über eine Redoxreaktion) in Polymere übergeht (Additionspolymerisation).

Bei der polymerisierbaren Gruppe kann es sich um eine Kohlenstoff-Kohlenstoff-Doppelbindung handeln, die aus der Gruppe bestehend aus Acrylaten, Methacrylaten, Vinylethern, Allylethern, Propenylethern, Alkenen, Dienen, ungesättigten Estern, Allytriazinen, Allylisocyanaten und N-Vinylamiden ausgewählt werden kann. Die polymerisierbare Kohlenstoff-Kohlenstoff-Doppelbindung lässt sich unter der Einwirkung von Licht und/oder Wärme und/oder auf chemischem Wege organisch polymerisieren. Sie ist eine unter der Einwirkung von aktinischer Strahlung photochemisch polymerisierbare Gruppe, insbesondere eine UV-polymerisierbare Gruppe. Zusätzlich oder alternativ zu der Polymerisationsreaktion der Kohlenstoff-Kohlenstoff-Doppelbindungen als solcher ist auch eine Umsetzung der diese Doppelbindungen enthaltenden Verbindungen mit Diaminen oder höheren Aminen oder Dithiolen oder höheren Thiolen über eine Michael-Addition (Thiol-En-Umsetzung bzw. die analoge Umsetzung mit Aminen) möglich. Die Polymerisation kann also auch eine Thiol-En-Reaktion umfassen oder daraus bestehen, d. h. eine Reaktion einer Thiolgruppe mit einer Kohlenstoff-Kohlenstoff-Doppelbindung. Die polymerisierbaren Gruppen in der Antihaftverbindung können eine Mischung aus Thiolgruppen und Kohlenstoff-Kohlenstoff-Doppelbindungen sein. Es ist auch möglich, dass die Antihaftverbindung Doppelbindungen enthält und der Haftvermittler ein oder mehrere Thiole aufweist. Auf diese Weise können die Polymerisation und die Vernetzung von Antihaftverbindung und Haftvermittler eingestellt werden.

Beispiele von oberflächenaktiven Verbindungen mit polymerisierbaren Gruppen sind Alkyl(meth)acrylate, Polysiloxan(meth)acrylate, Perfluoralkyl(meth)acrylate, Perfluorpolyether(meth)acrylate, Alkylvinylether, Polysiloxanvinylether, Perfluoralkylvinylether und Perfluorpolyethervinylether. Bevorzugt sind perfluorierte Verbindungen. Beispiele für perfluorierte Antihaftverbindungen sind Poly(1H,1H,2H,2H-perfluorodecylacrylat) oder oligomore Verbindungen auf der Basis von Hexafluorpropylenoxid (HFPO) wie Oligo-HFPO-2-hydroxyethylmethacrylatester. Die außergewöhnliche Oberflächenaktivität dieses Moleküls beruht auf der verzweigten Struktur der Perfluorpolyether-Kette mit den CF₃-Seitengruppen. Weitere Beispiele sind Oligo-HFPO-Urethanacrylate, die durch Umsetzen von verzweigten CF₃-Seitengruppen-tragenden Tri- bis Hexa-HFPO-(Oligomer)-Alkoholen mit 2-lsocyanatoethylacrylat erhalten werden. Bevorzugte Alkohole sind 2-{1,1,2,3,3,3-Hexafluor-2-[1,1,2,3,3,3-hexafluor-2-(heptafluorpropoxy)propoxy]propoxy}-2,3,3,3-tetrafluorpropan-1-ol (CAS 14620-81-6), 2,4,4,5,7,7,8,10,10,11,13,13,14,14,15,15,15-Heptadecafluor-2,5,8,11-tetrakis(trifluormethyl)-3,6,9,12-tetraoxapentadecan-1-ol (CAS 141977-66-4) und 1H,1H-Perfluoro(2,5,8,11,14-pentamethyl-3,6,9,12,15-oxaoctadecan-1-ol)(CAS 27617-34-1).

Besonders vorteilhaft als Antihaftverbindung ist das verzweigte perfluorierte Oligo-Etheracrylat-Monomer 1H,1H-Perfluor(2,5-dimethyl-3,6-dioxanonanoyl) acrylat (CAS-Nummer: 17559-01-2):

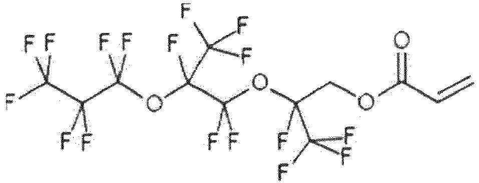

Durch die CF₃-Seitengruppen bzw. das erhöhte CF₃/CF₂-Verhältnis kann eine niedrige Oberflächenenergie der abgeschiedenen Polymerschicht erzielt werden.

Der Haftvermittler weist eine Phosphorsäure- oder Phosphonsäuregruppe sowie eine mit der Antihaftverbindung umsetzbare Gruppe als Funktionsgruppen auf. In der Regel sind diese Funktionsgruppen durch eine bifunktionelle Kopplungsgruppe miteinander verbunden. Die Phosphorsäure- oder Phosphonsäuregruppe geht mit dem Substrat eine kovalente Bindung ein, und die mit der Antihaftverbindung umsetzbare Gruppe geht mit der Antihaftverbindung eine kovalente Bindung ein. Das Substrat und die Antihaftverbindung werden also über den Haftvermittler kovalent verbunden. Bevorzugte Haftvermittler sind Verbindungen, die durch Veresterung der Phosphonsäure, Phosphorsäure und/oder Polyphosphorsäure, insbesondere Polyphosphorsäure, beziehungsweise von deren Anhydriden und/oder von deren Estern, mit einer hydroxygruppenhaltigen Verbindung erhalten werden. Vorzugsweise ist die hydroxygruppenhaltige Verbindung ein Polyol, beispielsweise ein Diol, wie ein Alkandiol, Alkantriol und/oder Alkanpolyol mit 2 bis 40 Kohlenstoffatomen, wobei die Hydroxygruppen vorzugsweise endständig sind. Konkrete hydroxygruppenhaltige Verbindungen sind Glykol, 1 ,3-Propandiol, 1,4-Butandiol, 1,5-Pentandiol, 1,6-Hexandiol, 1,8- Octandiol, 1,10-Decandiol, 1,12-Dodecandiol, 1,20-Eicosandiol, Glycerin und Trimethylolpropan. Der Haftvermittler weist eine mit der Antihaftverbindung umsetzbare Gruppe auf. Diese Gruppe kann eine Gruppe sein, die oben als polymerisierbare Gruppe der Antihaftverbindung beschrieben wurde. Ein Beispiel für einen Haftvermittler ist Phosphorsäure-2-hydroxyethylmethacrylat.

Die mechanische Stabilität, insbesondere die Abriebstabilität, und chemische Stabilität der abgeschiedenen Polymerschicht können durch Zugabe eines Vernetzers verbessert werden. Der Vernetzer unterscheidet sich von der Antihaftverbindung und dem Haftvermittler. Insbesondere ist er keine oberflächenaktive Verbindung und enthält keine Phosphorsäure- oder Phosphonsäuregruppe. Bevorzugte Vernetzer sind DEGDVE (Di(ethylenglycol)divinylether) und/oder V4D4 (1,3,5,7-Tetravinyl-1,3,5,7-tetramethylcyclotetrasiloxan). Die iCVD-Copolymerisation des perfluorierten Oligoetheralkylacrylats ergibt zusammen mit einem der bevorzugten Vernetzermolekülen äußerst stabile Beschichtungen mit extrem niedriger Oberflächenenergie.

Mit dem erfindungsgemäßen Verfahren kann ein antihaftbeschichtetes Substrat hergestellt werden. Dieses kann als Prägewerkzeug oder Formwerkzeug zur Replikation von Mikro- oder Nanostrukturen, beispielsweise in einem Nanoprägelithografieverfahren, eingesetzt werden. Mikro- oder Nanostrukturen sind Strukturen, die Vertiefungen mit einer Tiefe im Nanometer- oder Mikrometerbereich aufweisen, beispielsweise einer Tiefe von.1 nm bis 200 µm, vorzugsweise 10 nm bis 100 µm, stärker bevorzugt 100 nm bis 50 µm.

### Beispiele

Es wurde ein erfindungsgemäßes Verfahren durchgeführt. Dabei wurde mittels iCVD eine Polymerschicht auf eine Nickel-Oberfläche abgeschiedenen. Das Polymer wurde aus 1H,1H-Perfluoro(2,5-dimethyl-3,6-dioxanonanoyl)acrylat gebildet.

Die mittels iCVD abgeschiedene Antihaftbeschichtung zeigte eine hervorragende Konformität, was durch Messungen mit einem Rasterkraftmikroskop (AFM) an dem Prägewerkzeug vor und nach der Abscheidung gezeigt wurde.

Die Polymerschicht wies einen hohen Wasserkontaktwinkel von 109° und eine niedrige Oberflächenenergie von etwa 12,6 mJ/m² auf. Das heißt, es wurde eine hervorragende Hydrophobierung und damit eine Verringerung der Oberflächenenergie erzielt. Im Vergleich dazu beträgt der Wasserkontaktwinkel auf einer ungereinigten Nickel-Oberfläche typischerweise etwa 50°, und der Wasserkontaktwinkel auf einer mittels Plasma- bzw. basischen Piranha-Behandlung gereinigten und aktivierten Nickeloberfläche beträgt etwa 25°.

Es wurde eine Reihe von UV-Prägungen in einen repräsentativen Acrylat-basierten UV-Prägelack durchgeführt. Dabei wurden in regelmäßigen Abständen die Kontaktwinkel von sitzenden Wasser- und Diiodmethan-Tröpfchen gemessen. Es zeigte sich, dass zwischen dem ersten und dem hundertsten Abdruck der Kontaktwinkel nahezu unverändert blieb. Dieses Ergebnis belegt die Stabilität der Antihaftbeschichtung in UV-Prägeprozessen.

Der Wasserkontaktwinkel wird nach der ORWK-Methode berechnet. In der vorliegenden Erfindung werden die Oberflächenenergien mit der Methode nach Owens, Wendt, Rabel und Kaelble (OWRK) ermittelt (D. H. Kaelble, Dispersion-Polar Surface Tension Properties of Organic Solids. In: J. Adhesion 2 (1970), S. 66-81; D. Owens; R. Wendt, Estimation of the Surface Free Energy of Polymers. In: J. Appl. Polym. Sci 13 (1969), S. 1741-1747; W. Rabel, Einige Aspekte der Benetzungstheorie und ihre Anwendung auf die Untersuchung und Veränderung der Oberflächeneigenschaften von Polymeren. In: Farbe und Lack 77,10 (1971), S. 997-1005). Die OWRK-Methode ist eine Standardmethode zur Berechnung der freien Oberflächenenergie eines Festkörpers aus dem Kontaktwinkel mit mehreren Flüssigkeiten. Die freie Oberflächenenergie wird dabei in einen polaren Anteil und einen dispersen Anteil aufgespaltet.

## Patentansprüche

1. Verfahren zum Herstellen eines antihaftbeschichteten Substrats, welches das Aufbringen einer Antihaftverbindung auf ein Substrat mittels chemischer Gasphasenabscheidung umfasst, wobei die Antihaftverbindung eine oberflächenaktive Verbindung mit einer polymerisierbaren Gruppe ist und das Substrat metallhaltig ist und mit einem Haftvermittler modifiziert ist, wobei der Haftvermittler eine Phosphorsäure- oder Phosphonsäuregruppe sowie eine mit der Antihaftverbindung umsetzbare Gruppe aufweist.

2. Verfahren nach Anspruch 1, wobei das Substrat ein Metall oder eine Metalllegierung ist.

3. Verfahren nach Anspruch 1 oder 2, wobei die chemische Gasphasenabscheidung eine initiierte chemische Gasphasenabscheidung ist.

4. Verfahren nach einem der vorstehenden Ansprüche, wobei die Antihaftverbindung eine perfluorierte Verbindung ist.

5. Verfahren nach einem der vorstehenden Ansprüche, wobei die polymerisierbare Gruppe eine polymerisierbare Kohlenstoff-Kohlenstoff-Doppelbindung ist.

6. Verfahren nach einem der vorstehenden Ansprüche, wobei die Antihaftverbindung ein (Meth)acrylsäureester eines perfluorierten Oligoethers mit mindestens zwei CF₃-Gruppen ist.

7. Verfahren nach einem der vorstehenden Ansprüche, wobei die Antihaftverbindung 1H,1H-Perfluoro(2,5-dimethyl-3,6-dioxanonanoyl)acrylat ist.

8. Verfahren nach einem der vorstehenden Ansprüche, wobei der Haftvermittler ein Diester eines Diols mit Phosphorsäure und (Meth)acrylsäure ist.

9. Verfahren nach einem der vorstehenden Ansprüche, wobei das Aufbringen der Antihaftverbindung unter Einsatz eines Vernetzers erfolgt.

10. Verfahren nach einem der vorstehenden Ansprüche, wobei die chemische Gasphasenabscheidung eine initiierte chemische Gasphasenabscheidung ist, die Antihaftverbindung ein (Meth)acrylsäureester eines perfluorierten Oligoethers mit mindestens zwei CF₃-Gruppen ist und der Haftvermittler ein Diester eines Diols mit Phosphorsäure und (Meth)acrylsäure ist.

11. Antihaftbeschichtetes Substrat, herstellbar durch ein Verfahren nach einem der Ansprüche 1 bis 10.

12. Antihaftbeschichtetes Substrat nach Anspruch 11, das ein Prägewerkzeug oder Formwerkzeug ist.

13. Antihaftbeschichtetes Substrat nach Anspruch 12, wobei das Prägewerkzeug oder Formwerkzeug zur Replikation von Mikro- oder Nanostrukturen geeignet ist.

14. Verwendung eines antihaftbeschichteten Substrats nach Anspruch 11 oder 12 als Werkzeug zum Prägen oder Formen von Mikro- oder Nanostrukturen.
